# EUROPÄISCHE PATENTSCHRIFT

(11) **EP 2 796 886 B1**
(45) Veröffentlichungstag und Bekanntmachung des Hinweises auf die Patenterteilung: **06.09.2017**
(21) Anmeldenummer: 13164947.7
(22) Anmeldetag: 23.04.2013
(51) Int. Cl.: G01R 27/18, G01R 31/02, G01R 31/08

(54) **Schaltungsanordnung zum Lokalisieren von Isolationsfehlern**
Circuit assembly for locating of insulation faults
Agencement de circuit pour la localisation de défauts d'isolement

(43) Veröffentlichungstag der Anmeldung: 29.10.2014
(73) Patentinhaber: Technische Universität Graz, 8010 Graz (AT); Austrian Power Grid AG, 1220 Wien (AT)
(72) Erfinder: Achleitner, Georg, 1150 Wien (AT); Raunig, Christian, 8010 Graz (AT); Fickert, Lothar, 8042 Graz St. Peter (AT)
(74) Vertreter: Patentanwaltskanzlei Matschnig & Forsthuber OG

(56) Entgegenhaltungen:
- EP-A2- 0 833 423
- DE-A1- 4 339 946
- DE-A1-102011 050 346

## Beschreibung

Die Erfindung betrifft eine Schaltungsanordnung zur Lokalisierung von Isolationsfehlern gegen Erde (bzw. zur Ortung von Abzweigen bei auftretenden Isolationsfehlern gegen Erde) in Gleichspannungsnetzen, bei welcher die Spannung einer Gleichspannungsquelle an zwei Einspeiseleiter des zumindest zwei Abzweige aufweisenden Gleichspannungsnetzes gelegt ist sowie ein Verfahren zum Erfassen von Isolationsfehlern.

Gleichspannungsnetze finden in zahlreichen Gebieten, wie beispielsweise in der Verkehrstechnik, in der Energietechnik sowie in Bereichen mit hohen Anforderungen an die Versorgungssicherheit oder an den Personenschutz, Anwendung. Aufgrund der speziellen Eigenschaften von Gleichspannungsnetzen können einige der bei den Wechselspannungsnetzen üblichen Schutzmaßnahmen nicht in gleicher Weise umgesetzt werden. So werden für Wechselspannungsnetze unter anderem TN-System (franz. "*Terre Neutre*"), TT-Systeme (franz. "*Terre Terre*") sowie IT-Systeme (franz. "*Isole Terre*") eingesetzt, die sich durch Ausführung eines Neutralleiters, Ausführung und Anbindung der Transformatoren und Implementierung der Erdung und der Anbindung der Verbraucher unterscheiden. Die Auslegung des elektrischen Netzes, der Verbraucher sowie der Schutzmaßnahmen bestimmen damit Reaktionen auf Isolationsfehler gegen Erde (also eine elektrische Verbindung einer Phase mit Erdpotential). Je nach Anwendungsfall werden dabei unterschiedliche Anforderungen an die Selektivität, Schnelligkeit, Empfindlichkeit, Genauigkeit, Zuverlässigkeit, Unabhängigkeit und Wirtschaftlichkeit gestellt.

Zur globalen Erkennung von Isolationsfehlern gegen Erde in Gleichspannungsnetzen sind aus dem Stand der Technik einige Maßnahmen bekannt. So zeigt das Dokument DE 43 39 946 A1 ein Verfahren zur Isolationsüberwachung, bei welchem Isolationsfehler gegen Erde erkannt, aber nicht geortet werden können. Dies ist insbesondere bei stark verzweigten Netzen problematisch. Eine Möglichkeit zur Fehlerortung ist beispielsweise aus dem Dokument EP 1505398 A1 bekannt geworden, bei welcher dem Gleichspannungsnetz eine aktive Einspeisung überlagert wird und mit Hilfe derer eine Lokalisierung des Isolationsfehlers ermöglicht ist. Das Vorsehen einer aktiven Einspeisung ist allerdings kostenintensiv und kann zu Fehlfunktionen von im elektrischen Netz befindlichen Verbrauchern führen.

Aus dem Dokument EP 0833 423 A2 ist eine Vorrichtung sowie ein Verfahren bekannt geworden, bei welchem Versorgungsleitungen mittels Widerständen gezielt mit Erdpotential verbunden werden können. Dabei werden die Spannungswerte der Versorgungsleitungen in Bezug auf das Erdpotential gemessen und zur Berechnung der Widerstandswerte der Versorgungsleitungen gegeben Erde herangezogen. Die berechneten Widerstandswerte werden mit Referenzwerten verglichen, wobei basierend auf der Abweichung von den Referenzwerten auf Isolationsfehler gegen Erde rückgeschlossen wird.

Den bekannten Maßnahmen zur Lokalisierung von Isolationsfehlern gegen Erde in Gleichspannungsnetzen ist dabei gemein, dass diese lediglich Kompromisse hinsichtlich der obig angeführten Anforderungen darstellen. Derzeit funktionieren Lokalisierungsmaßnahmen hauptsächlich dadurch, dass einzelne Abzweige nacheinander manuell (bzw. händisch) abgeschaltet werden. Wenn durch das Abschalten eines Abzweiges der Fehler verschwindet, war die Lokalisierung des fehlerbehafteten Abganges erfolgreich. Dies ist jedoch eine große Belastung für Gleichstromschalter und eine Gefährdung für das Betriebspersonal und führt zu unnötigen Unterbrechungen der einzelnen Stromkreise.

Eine Aufgabe der Erfindung besteht daher darin, eine Schaltungsanordnung zur Ortung von Isolationsfehlern gegen Erde in Gleichspannungsnetzen zu schaffen, welche einfach, zuverlässig, genau, kostengünstig und möglichst unabhängig realisierbar ist.

Diese Aufgabe wird mit einer Schaltungsanordnung der eingangs genannten Art gelöst, welche erfindungsgemäß einen Auswahlschalter zur wahlweisen Verbindung der Einspeiseleiter mit Erdpotential sowie eine jedem zu überprüfenden Abzweig zugeordnete Erfassungseinrichtung zum Erfassen einer Stromänderung in dem Abzweig aufweist.

Dank der Erfindung können Isolationsfehler kostengünstig und selektiv lokalisiert werden. Die erfindungsgemäße Schaltungsanordnung benötigt keine zusätzlichen Einspeisemittel, beugt durch Detektionsvorgänge verursachte Störungen der Verbraucher vor und zeichnet sich durch Langlebigkeit, eine hohe Genauigkeit und Zuverlässigkeit aus. Darüber hinaus ist die Funktionsweise der Erfindung äußerst robust und erlaubt eine Erkennung niederohmiger wie auch hochohmiger Fehler. Die Stromänderungen können durch eine direkte oder eine indirekte Messung erfasst werden.

Unter dem Ausdruck "wahlweise Verbindung der Einspeiseleiter mit Erdpotential" wird dabei verstanden, dass auch nur ein Einspeiseleiter (also eine Phase) mit dem Erdpotential verbunden werden kann. Selbstverständlich kann auf eine Verbindung ("erde") eine Trennung ("enterden") folgen. Beispielsweise impliziert eine wahlweise Verbindung eines/der Einspeiseleiter/s mit Erdpotential nach einer vorgebbaren zeitlichen Abfolge eine zwischenzeitliche/vorausgehende Trennung eines/der Einspeiseleiter/s von Erdpotential. Isolationsfehler gegen Erde, die in durch das Gleichspannungsnetz versorgten Verbrauchern auftreten, sind im Zuge dieser Anmeldung ebenso als dem Gleichspannungsnetz zugehörige Isolationsfehler zu betrachten.

Um einen gezielten Einsatz der erfindungsgemäßen Schaltungsanordnung zu ermöglichen und deren Lebensdauer zusätzlich zu erhöhen, ist in einer vorteilhaften Ausführungsform vorgesehen, dass zwischen der Gleichspannungsquelle und den Einspeiseleitern eine Fehlererkennungseinrichtung zur Erfassung und Auswertung von Netzparametern angeordnet ist, wobei die Fehlererkennungseinrichtung zum Vergleich von Ist-Werten der Netzparameter mit vorgebbaren Soll-Werten eingerichtet ist und bei Eintritt einer vorgebbaren Abweichung von den Soll-Werten eine Ansteuerung für den Auswahlschalter von einem Ruhezustand in einen aktivierten Zustand versetzt, wobei die Ansteuerung die wahlweise Verbindung der Einspeiseleiter mit Erdpotential ausschließlich während der Dauer des aktivierten Zustands zulässt.

In einer besonders einfachen Ausgestaltung ist die Fehlererkennungseinrichtung ein Widerstandsnetzwerk mit zumindest einer Spannungsmesseinrichtung. So kann beispielsweise das Widerstandsnetzwerk als ein von den Einspeiseleitern versorgter hochohmiger Spannungsteiler ausgebildet sein, wobei das Potential eines Referenzpunktes des Spannungsteilers mit dem Erdpotential verglichen wird.

In einer vorteilhaften Ausführungsform der Erfindung ist zwischen dem Auswahlschalter und dem Erdpotential ein mittels eines Hilfsschalters kurzschließbarer Hilfswiderstand vorgesehen. Auf diese Weise kann eine durch die Verbindung eines Einspeiseleiters mit Erdpotential verursachte Stromänderung einfach begrenzt werden.

Wird anhand der erfindungsgemäßen Schaltungsanordnung ein Isolationsfehler gegen Erde in einem Abzweig entdeckt, so können entsprechende Maßnahmen zur Reaktion darauf veranlasst werden (die durch die Schaltungsanordnung ausgelöst werden können). So könnten Warnleuchten oder Signale aktiviert werden, ein Eintrag in einem Überwachungsprotokoll erstellt werden oder der Abzweig automatisch oder manuell abgeschaltet werden. Um eine Abschaltung durch die Schaltungsanordnung bzw. die Erfassungseinrichtung (automatisch oder nach manueller Bestätigung) zu ermöglichen, ist in einer Weiterbildung der Erfindung vorgesehen, dass zumindest ein Abzweig durch die Erfassungseinrichtung steuerbare Leitungsschutzelemente aufweist. Vorzugsweise verfügt dabei jeder zu überprüfende Abzweig über durch dessen Erfassungseinrichtung steuerbare Leitungsschutzelemente.

Die Erfindung betrifft des Weiteren ein Verfahren zum Lokalisieren von Isolationsfehlern, bei welchem eine Gleichspannungsquelle Einspeiseleiter eines zumindest zwei Abzweige aufweisenden Netzes speist, wobei die Einspeiseleiter wahlweise mit Erdpotential verbunden (oder getrennt) werden und eine dadurch hervorgerufene Änderung zumindest des Stromes in den Abzweigen erfasst wird. Die Stromänderung kann dabei durch eine direkte oder eine indirekte Messung erfasst werden.

Dank des erfindungsgemäßen Verfahrens ist es möglich, Isolationsfehler kostengünstig und selektiv zu lokalisieren. Das erfindungsgemäße Verfahren setzt keine zusätzlichen Einspeisemittel voraus, beugt durch Detektionsvorgänge verursachte Störungen der Verbraucher vor und zeichnet sich durch einen schonenden Einsatz der Verwendeten Bauteile sowie durch eine hohe Zuverlässigkeit aus. Darüber hinaus ist das erfindungsgemäße Verfahren äußerst robust und erlaubt eine Erkennung niederohmiger wie auch hochohmiger Fehler. Die Stromänderungen können durch eine direkte oder eine indirekte Messung erfasst werden.

In einer Weiterbildung des erfindungsgemäßen Verfahrens ist vorgesehen, dass die erfasste Änderung zumindest des Stromes nach vorgebbaren Kriterien geprüft wird und ergebnisabhängig davon den Abzweigen zugeordnete Leitungsschutzmechanismen gesteuert werden. So können Warnleuchten oder Signale aktiviert, oder ein Eintrag in einem Überwachungsprotokoll erstellt werden.

Auch kann es vorgesehen sein, dass die erfasste Änderung zumindest des Stromes nach vorgebbaren Kriterien geprüft wird und ergebnisabhängig davon den Abzweigen zugeordnete Leitungsschutzmechanismen die Abzweige automatisch von den Einspeiseleitern trennen. Eine gezielte Abschaltung des fehlerbehafteten Abzweiges ist dadurch in einfacher Weise möglich.

Es ist besonders vorteilhaft, wenn die Verbindung (bzw. das Trennen) der jeweilige Einspeiseleiter mit (von) Erdpotential nach einer vorgebbaren zeitlichen Abfolge erfolgt. So kann die Verbindung der jeweiligen Einspeiseleiter mit Erdpotential nach einem Muster, nach vorgebbaren Intervallen oder nach einem Takt erfolgen, die besonders gut zu Fehlererkennung geeignet sind.

Die Langlebigkeit der für das erfindungsgemäße Verfahren verwendeten Komponenten kann weiter gesteigert werden, indem in einer günstigen Realisierung die zwei Einspeiseleiter auf Isolationsfehler gegen Erde geprüft werden, und dass nach Feststellung eines Isolationsfehlers gegen Erde die Einspeiseleiter wahlweise mit Erdpotential verbunden werden. Die Einspeiseleiter können, wie zuvor erwähnt, im Allgemeinen regelmäßig zu Testzwecken mit in einer vorgebbaren Abfolge mit Erdpotential verbunden werden. Es hat sich in der günstigen Realisierung allerdings als besonders vorteilhaft erwiesen, wenn die Einspeiseleiter ausschließlich nach Feststellung eines Isolationsfehlers gegen Erde nach einer vorgebbaren Abfolge mit Erdpotential verbunden werden. So können durch das Verfahren eingesetzte Bauteile sowie das Gleichspannungsnetz inklusive den Verbrauchern geschont werden und unerwünschte Einflüsse durch Potentialänderung der Einspeiseleiter minimiert werden.

In einer ersten Variante des erfindungsgemäßen Verfahrens ist vorgesehen, dass ausschließlich jener Einspeiseleiter mit Erdpotential verbunden wird, welche den Isolationsfehler gegen Erde aufweist. Dies hat den Vorteil, dass eine durch die Verbindung mit dem Erdpotential verursachte Stromänderung einerseits ausreichend groß ist, um detektiert werden zu können, und andererseits ändert sich für die Verbraucher das Fehlerbild nicht, da bei einem bereits bestehenden Isolationsfehler einer Phase nur der Fehlerort "verschoben" wird, wodurch die Beeinflussung andere im Gleichspannungsnetz vorhandene Teilnehmer (einzelne Bauteile, Schutzeinrichtungen, Messeinrichtungen, Verbraucher) nicht gestört werden.

Alternativ dazu ist in einer zweiten Variante des erfindungsgemäßen Verfahrens vorgesehen, dass ausschließlich jener Einspeiseleiter mit Erdpotential verbunden wird, welche keinen Isolationsfehler gegen Erde aufweist. Jener Einspeiseleiter, welcher keinen Isolationsfehler gegen Erde aufweist wird im Fachjargon auch als "gesunde Phase" bezeichnet. Eine durch die Verbindung mit dem Erdpotential verursachte Stromänderung ist dabei besonders hoch, wodurch eine rasche Detektion ermöglicht ist sowie die Ausführung optionaler Schutzmaßnahmen erleichtert sein kann (z.B. das Auslösen von Leitungsschutzelementen).

Die Erfindung samt weiteren Vorteilen ist im Folgenden anhand mehrerer beispielhafter und nicht einschränkender Ausführungsformen näher erläutert, die in den Figuren veranschaulicht sind. Dabei zeigen
Fig. 1 ein Ersatzschaltbild eines Gleichspannungsnetzes gemäß dem Stand der Technik,
Fig. 2 das Ersatzschaltbild des Gleichspannungsnetzes gemäß Fig. 1 im Fehlerfall,
Fig. 3 ein Ersatzschaltbild einer erfindungsgemäßen Schaltungsanordnung in einem Gleichspannungsnetz und
Fig. 4 ein Ablaufdiagramm eines erfindungsgemäßen Verfahrens.

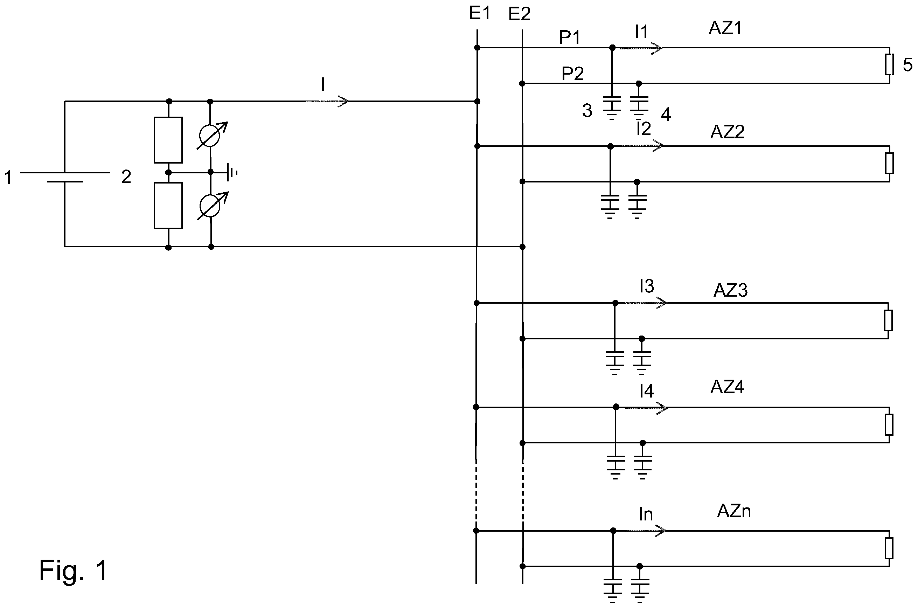

Fig. 1 zeigt ein Ersatzschaltbild eines aus dem Stand der Technik bekannten Gleichspannungsnetzes. Das Gleichspannungsnetz verfügt über zumindest eine Gleichspannungsquelle 1, welche beispielsweise ein durch einen Gleichrichter oder einen Hochsetzsteller gestützter elektrochemischer Speicher sein kann. Generell sind als Gleichspannungsquellen beliebige dem Fachmann bekannte Quellen geeignet, die das Gleichspannungsnetz mit Gleichspannung versorgen.

Die Gleichspannungsquelle 1 versorgt einen ersten und einen zweiten Einspeiseleiter (verbunden mit einer der Gleichspannungsquelle 1 zugeordneten ersten und einer zweiten Phase P1 und P2) E1 und E2, welche einzelne Abzweige AZ1, AZ2, ...AZn speisen. Die Abzweige AZ1, AZ2, ...AZn dienen zur Versorgung einzelner Verbraucher 5, wobei je nach Polarität ein Stromfluss von dem ersten Einspeiseleiter E1 über den Verbraucher 5 hin zum zweiten Einspeiseleiter E2 oder umgekehrt erfolgt. Ein Gesamtlastrom I teilt sich in einzelne in den Abzweigen AZ1, AZ2, ...Azn fließende Lastströme I1, I2,..., In auf. Die Abzweige AZ1, AZ2, ...AZn weisen zur Versorgung der Verbraucher 5 zwei Phasen P1 und P2 mit jeweils einer Kapazität gegen Erde (bzw. Erdpotential) auf, welche durch Ersatzkapazitäten 3 und 4 repräsentiert werden. Die Anzahl der Abzweige AZ1, AZ2, ...AZn unterliegt im Allgemeinen keinen Einschränkungen und wird in der Praxis entsprechend der Einspeiseleistung, der Anzahl der Verbraucher 5 sowie der Netzeigenschaften passend gewählt. Die Abzweige AZ1, AZ2, ...AZn können sich durch die Anzahl der Verbraucher 5, ihre räumliche Ausdehnung, ihre Leitungseigenschaften, ihre Schutzelemente usw. unterscheiden. Zur übersichtlicheren Darstellung wurden nur in Abzweig AZ1 sämtliche relevante Bezugszeichen eingefügt. Diese Bezugszeichen gelten allerdings für die weiteren Abzweige AZ2, ...AZn in analoger Weise.

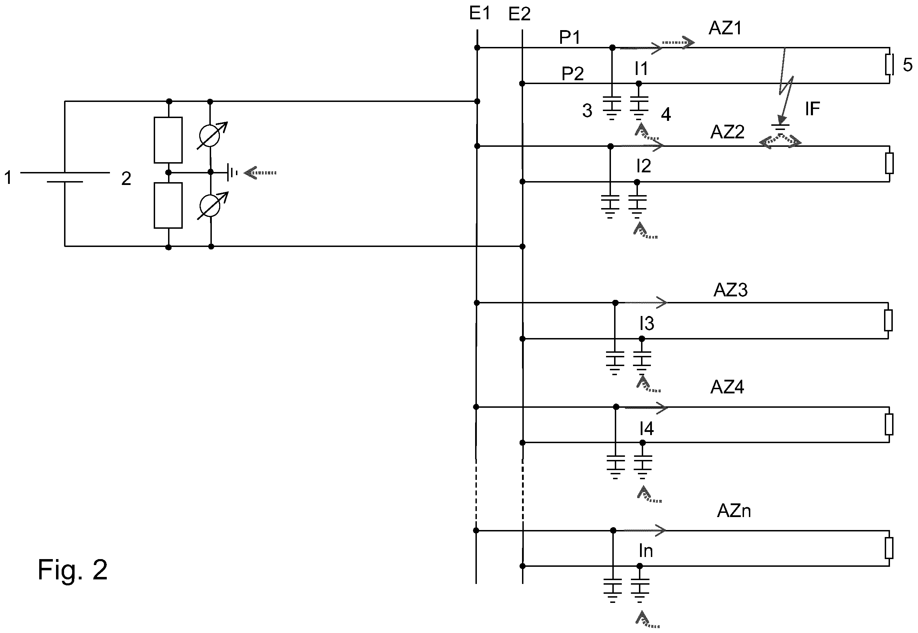

Zwischen der Gleichspannungsquelle 1 und den Einspeiseleitern E1 und E2 ist eine Fehlererkennungseinrichtung 2 eingerichtet, welche der Erkennung von Isolationsfehlern gegen Erde dient. Näheres dazu wird in der Beschreibung der Fig. 2 ausgeführt.

Fig. 2 zeigt das Ersatzschaltbild des Gleichspannungsnetzes gemäß Fig. 1 im Fehlerfall. Es handelt sich dabei um einen Isolationsfehler gegen Erde, welcher in der ersten Phase P1 im Abzweig AZ1 aufgetreten ist. Die erste Phase P1 nimmt somit Erdpotential an. Das Gleichspannungsnetz ist in der gezeigten Ausführungsform zwar weiterhin funktionsfähig, jedoch besteht das Risiko, dass ein weiterer Isolationsfehler (in der zweiten Phase P2) das System aufgrund hoher Ströme und/oder einem Einbruch der Versorgungsspannung zum Ausfall bringt oder Benutzer durch Auftreten von Berührungsspannungen gefährdet. Die Erkennung von Isolationsfehlern gegen Erde ist daher von besonderer Bedeutung.

Hierfür misst die Fehlererkennungseinrichtung 2 die Spannung/en, die zwischen einem in einem Widerstandsnetzwerk geerdeten Knotenpunkt und dem ersten und/oder dem zweiten Einspeiseleiter E1 oder E2 (bzw. der damit verbundenen Phasen P1 oder P2) auftreten. Das Widerstandsnetzwerk ist dabei mit dem ersten und dem Einspeiseleiter E1 und E2 verbunden und der geerdete Knotenpunkt befindet sich innerhalb des Widerstandsnetzwerks und zwischen den beiden Einspeiseleitern E1 und E2. Im einfachsten Fall handelt es sich bei dem Widerstandsnetzwerk um zwei baugleiche hochohmige Widerstände, die in zwischen die Einspeiseleiter E1 und E2 in Serie geschaltet sind und somit im fehlerfreien Fall einen Spannungsteiler bilden, bei welchem jeweils 50% der zwischen den beiden Einspeiseleitern E1 und E2 auftretenden Differenzspannung an den einzelnen Widerständen anliegt. Der Punkt, an welchem die beiden Widerstände verbunden sind, ist dabei der zu erdende Punkt. Kommt also, wie in Fig. 2 dargestellt, die erste Phase P1 aufgrund eines Isolationsfehlers mit Erdpotential in Berührung, so nimmt die erste Phase P1 Erdpotential an und die Spannung zwischen dem Einspeiseleiter E1 bzw. der ersten Phase P1 und dem geerdeten Knotenpunkt der Fehlererkennungseinrichtung 2 senkt sich gegen 0V. Gleichzeitig erhöht sich die Spannung zwischen dem geerdeten Knotenpunkt und dem zweiten Einspeiseleiter E2 auf die volle, zwischen dem ersten und dem zweiten Einspeiseleiter E1 und E2 auftretende Differenzspannung. Zur Feststellung eines Isolationsfehlers reicht daher lediglich eine einziges Spannungsmessgerät bzw. Spannungsmesseinrichtung, die die Spannung zwischen einem Einspeiseleiter E1 oder E2 und dem geerdeten Knotenpunkt überwacht. Es ist allerdings aus Sicherheits- und Redundanzgründen vorteilhaft, wenn das Potential beider Einspeiseleiter E1 und E2 in Bezug auf den geerdeten Knotenpunkt überwacht wird. Ein Fehlerstrom IF fließt über die Fehlerstelle zu Erdpotential und überlagert sich dem Laststrom I1. Aufgrund der Ersatzkapazität 4 und des Widerstandsnetzwerkes 2, fließt der Fehlerstrom IF vom Erdpotential zurück zu der Phase P2 bzw. dem Einspeiseleiter E2 (wie durch strichlierte Pfeilsymbole angedeutet wird). Die Höhe des Fehlerstromes IF ist dabei von dem Fehlerwiderstand und der Größe der Kapazitäten abhängig.

Diese Fehlererkennungseinrichtung 2 erlaubt eine zuverlässige Erkennung eines Isolationsfehlers einer Phase P1 oder P2 gegen Erde, kann allerdings keine Information über den Fehlerort zur Verfügung stellen. Eine Fehlersuche und Behebung ist daher vor allem bei umfangreich verzweigten Netzen besonders schwierig, wodurch für den Zeitraum des Fehlerauftritts die Betriebssicherheit des Gleichspannungsnetzes für einen längeren Zeitraum gefährdet sein kann oder das Gleichspannungsnetz generell abgeschaltet werden muss. Einzelne Abzweige AZ1, AZ2, ...AZn können dabei nicht gezielt untersucht und selektiv behandelt werden.

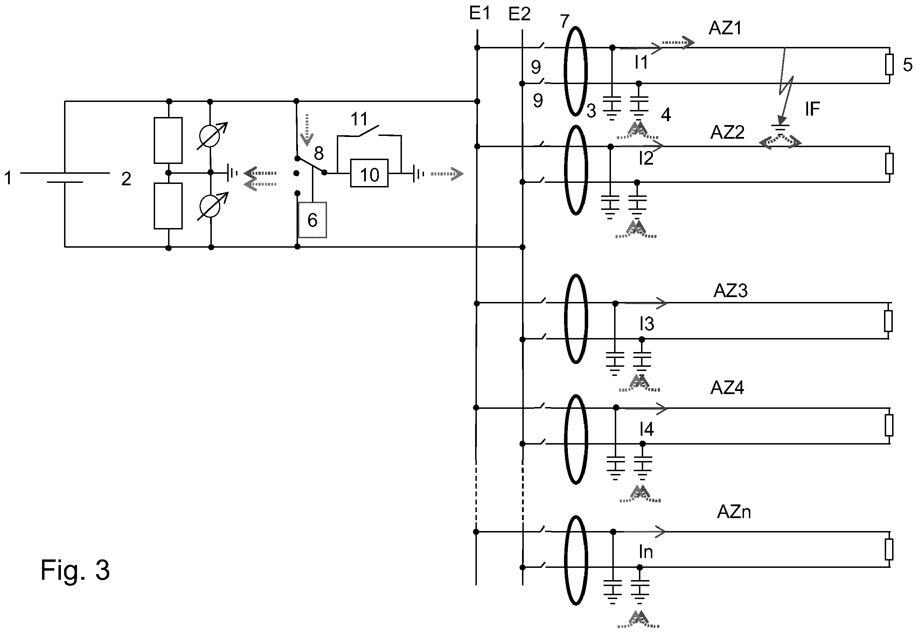

Fig. 3 veranschaulicht ein Ersatzschaltbild einer erfindungsgemäßen Schaltungsanordnung in einem Gleichspannungsnetz. Die Abzweige AZ1, AZ2, ...AZn verfügen darin über Leitungstrenn- oder -schutzelemente (9), welche schützende Maßnahmen wie beispielsweise die Trennung einzelner Abzweige AZ1, AZ2, ...AZn von den Phasen P1 und P2 durchführen können. Zusätzlich verfügen zumindest jene Abzweige AZ1, AZ2, ...AZn, die durch die erfindungsgemäße Schaltungsanordnung überprüfbar sein sollen, über eine Erfassungseinrichtung 7. Diese Erfassungseinrichtung 7 ist zur Messung von Netzparametern eingerichtet, wobei beispielsweise zeitliche Änderungen dieser Netzparameter dazu heran gezogen werden, um auf einen Isolationsfehler gegen Erde innerhalb eines Abzweiges AZ1, AZ2, ...AZn rückschließen zu können.

Die Erfassungseinrichtung 7 wirkt in Verbindung mit einem Auswahlschalter 8, der dazu eingerichtet ist, wahlweise eine Verbindung einer der beiden Einspeiseleiter E1 und E2 mit Erde herzustellen. Der Auswahlschalter 8 befindet sich vorzugsweise zwischen der Gleichspannungsquelle 1 und den Einspeiseleitern E1 und E2. Die Leitungsschutzelemente 9, die Erfassungseinrichtung 7 sowie die Verbraucher 5 sind nachgeschaltet.

Das Gleichspannungsnetz gemäß Fig. 3 weist im Abzweig AZ1 analog zu Fig. 2 in der ersten Phase P1 einen Isolationsfehler gegen Erde auf. Verbindet der Auswahlschalter 8 im gezeigten Beispiel den ersten Einspeiseleiter E1 und somit die erste Phase P1 mit Erdpotential, so führt dies zu einer messbaren Stromänderung im fehlerbehafteten Abzweig AZ1, die durch die Erfassungseinrichtung 7 erfasst wird. Der Strom fließt nun nicht mehr nur über die Fehlerstelle gegen Erde sondern auch über den Auswahlschalter 8. Dadurch kommt es zu einer Stromänderung des Fehlerstromes IF. Die Erfassung des zeitlichen Verlaufes der Stromänderung durch die Erfassungseinrichtung 7 kann beispielsweise durch eine Auswertung der Messwertänderung einer Summenstrommessung oder der Messung mittels eines Ringstromwandlers oder eines Hallstromwandlers erfolgen. Alternativ dazu kann der Auswahlschalter 8 auch den zweiten Einspeiseleiter E2 (also den nicht fehlerbehafteten Einspeiseleiter) bzw. die zweite Phase P2 (welche in diesem Beispiel die gesunde Phase ist) mit Erdpotential verbinden ("erden"; ein Trennen wird als "enterden" bezeichnet). Die dadurch verursachten Ströme bzw. Stromänderungen sind ausgeprägter als im zuvor geschilderten Fall. Die Summenstrom- bzw. Stromänderungen (die als "Ortungsstrom/ströme" dienen) in den Abzweigen AZ1, AZ2, ...AZn können durch die jeweilig zugeordnete Erfassungseinrichtung 7 erkannt und ausgewertet werden. Eine mögliche Einschaltung eines Hilfs-Widerstandes 10 durch Öffnen eines Hilfs-Schalters 11 in den Strompfad zwischen dem Auswahlschalter 8 und Erde bewirkt eine fallweise zweckmäßige Begrenzung des Ortungsstromes.

Je nach Anwendung und Einstellung der Erfassungseinrichtung 7 kann zur Fehlererkennung ein Verbinden der gesunden Phase oder der fehlerbehafteten Phase mit Erdpotential erwünscht sein. Auch ist es denkbar, dass der Auswahlschalter 8 nur ausschließlich eine der beiden Phasen P1 bzw. P2 mit Erdpotential verbinden kann, der Auswahlschalter 8 also nur zwei Schaltstellungen bzw. Schaltzustände aufweist. Je nachdem, welche Phase P1 oder P2 einen Isolationsfehler gegen Erde aufweist, wird dabei entweder die gesunde oder die fehlerbehaftete Phase P1 oder P2 geerdet.

Die Erfassungseinrichtung 7 kann bei Erkennung eines Isolationsfehlers gegen Erde Warnleuchten und/oder andere Signale aktivieren, ein Eintrag in einem Überwachungsprotokoll erstellen oder den fehlerbehafteten Abzweig AZ1, AZ2 und/oder ...AZn automatisch oder nach manueller Bestätigung abschalten, indem die Leitungsschutzelemente 9 aktiviert werden.

Das wahlweise Erden bzw. Enterden eines fehlerbehafteten Einspeiseleiters E1 oder E2 bzw. einer Phase P1 oder P2 durch Verbinden bzw. Trennen des jeweiligen Einspeiseleiters mit Erdpotential nach einer vorgebbaren zeitlichen Abfolge mittels des Auswahlschalters 8 kann in einem vorgebbaren Zeitintervall (-muster) erfolgen. Besonders vorteilhaft ist es aber, wenn die Fehlererkennungseinrichtung 2 Ist-Werte der Netzparameter mit vorgebbaren Soll-Werten vergleicht und bei Eintritt einer vorgebbaren Abweichung von den Soll-Werten eine Ansteuerung 6 für den Auswahlschalter 8 von einem Ruhezustand in einen aktivierten Zustand versetzt, wobei die Ansteuerung 6 die wahlweise Verbindung der Einspeiseleiter E1 oder E2 ausschließlich während der Dauer des aktivierten Zustands zulässt.

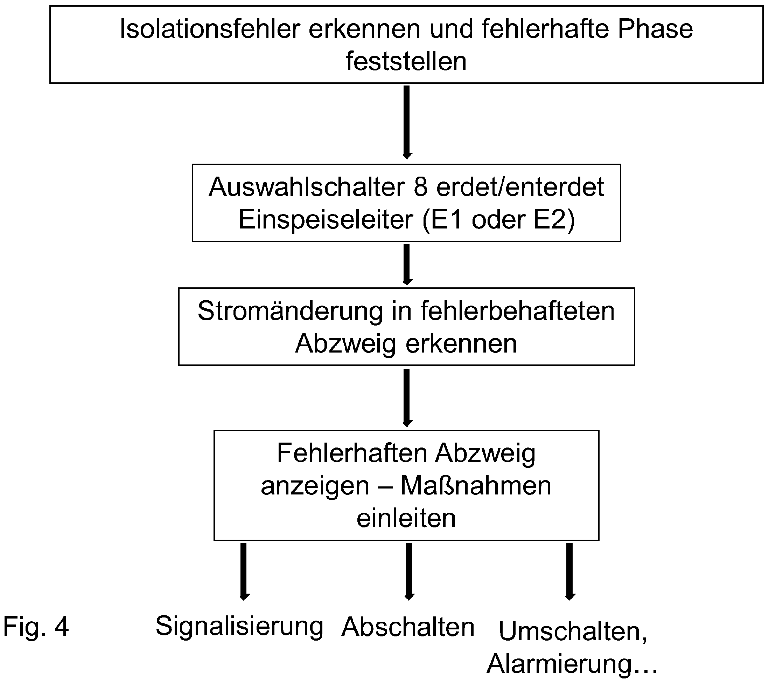

Fig. 4 zeigt ein Ablaufdiagramm eines erfindungsgemäßen Verfahrens, nach welchem die Erkennung und Lokalisierung von Isolationsfehlern gegen Erde in Gleichspannungsnetzen erfolgt. Analog zu den obigen Ausführungen erdet der Auswahlschalter 8 wahlweise einen Einspeiseleiter E1 oder E2, wobei Summenstrom- bzw. Stromänderungen in den Abzweigen AZ1, AZ2, ...AZn erfasst werden. Wird eine signifikante Stromänderung festgestellt, so können geeignete Maßnahmen zur Anzeige oder zur Behebung des Fehlers vorgenommen werden, wie beispielsweise das Aktivieren von Warnleuchten oder anderen Signalen, das Erstellen von Einträgen in Überwachungsprotokollen, die Abschaltung des betroffenen Abzweiges AZ1, AZ2, ...AZn oder das Ergreifen sonstiger Maßnahmen. Zur Fehlererkennung ist dabei vorzugsweise die Fehlerkennungseinrichtung 2 vorgesehen, mit Hilfe derer die fehlerhafte Phase festgestellt werden kann.

Der dieser Erfindung zu Grunde liegende Gedanke kann in dem Fachmann bekannter Weise abgewandelt werden und ist für den Einsatz bei unterschiedlichen Formen von Gleichspannungsnetzen geeignet.

## Patentansprüche

1. Schaltungsanordnung zur Lokalisierung von Isolationsfehlern gegen Erde in Gleichspannungsnetzen, bei welcher die Spannung einer Gleichspannungsquelle (1) an zwei Einspeiseleiter (E1, E2) des zumindest zwei Abzweige (AZ1, AZ2, ...AZn) aufweisenden Gleichspannungsnetzes gelegt ist,
**gekennzeichnet durch**
einen Auswahlschalter (8) zur wahlweisen Verbindung der Einspeiseleiter (E1, E2) mit Erdpotential sowie eine jedem zu überprüfenden Abzweig (AZ1, ...AZn) zugeordnete Erfassungseinrichtung (7) zum Erfassen einer Stromänderung in dem Abzweig.

2. Schaltungsanordnung nach Anspruch 1, **dadurch gekennzeichnet, dass** zwischen der Gleichspannungsquelle (1) und den Einspeiseleitern (E1, E2) eine Fehlererkennungseinrichtung (2) zur Erfassung und Auswertung von Netzparametern angeordnet ist, wobei die Fehlererkennungseinrichtung (2) zum Vergleich von Ist-Werten der Netzparameter mit vorgebbaren Soll-Werten eingerichtet ist und bei Eintritt einer vorgebbaren Abweichung von den Soll-Werten eine Ansteuerung (6) für den Auswahlschalter (8) von einem Ruhezustand in einen aktivierten Zustand versetzt, wobei die Ansteuerung (6) die wahlweise Verbindung der Einspeiseleiter (E1, E2) mit Erdpotential ausschließlich während der Dauer des aktivierten Zustands zulässt.

3. Schaltungsanordnung nach Anspruch 2, **dadurch gekennzeichnet, dass** die Fehlererkennungseinrichtung (2) ein Widerstandsnetzwerk mit zumindest einer Spannungsmesseinrichtung ist.

4. Schaltungsanordnung nach Anspruch 1 oder 2, **dadurch gekennzeichnet, dass** zwischen dem Auswahlschalter (8) und dem Erdpotential ein mittels eines Hilfsschalters (11) kurzschließbarer Hilfswiderstand (10) vorgesehen ist.

5. Schaltungsanordnung nach einem der Ansprüche 1 bis 4, **dadurch gekennzeichnet, dass** zumindest ein Abzweig (AZ1) durch die Erfassungseinrichtung (7) steuerbare Leitungsschutzelemente (9) aufweist.

6. Verfahren zum Lokalisieren von Isolationsfehlern, bei welchem eine Gleichspannungsquelle (1) Einspeiseleiter (E1, E2) eines zumindest zwei Abzweige (AZ1, AZ2, ...AZn) aufweisenden Netzes speist, wobei die Einspeiseleiter (E1, E2) wahlweise mit Erdpotential verbunden werden und eine dadurch hervorgerufene Änderung zumindest des Stromes in den Abzweigen (AZ1, AZ2, ...AZn) erfasst wird.

7. Verfahren nach Anspruch 6, **dadurch gekennzeichnet, dass** die erfasste Änderung zumindest des Stromes nach vorgebbaren Kriterien geprüft wird und ergebnisabhängig davon den Abzweigen (AZ1, AZ2, ...AZn) zugeordnete Leitungsschutzmechanismen gesteuert werden.

8. Verfahren nach Anspruch 6, **dadurch gekennzeichnet, dass** die erfasste Änderung zumindest des Stromes nach vorgebbaren Kriterien geprüft wird und ergebnisabhängig davon den Abzweigen (AZ1, AZ2, ...AZn) zugeordnete Leitungsschutzmechanismen die Abzweige (AZ1, AZ2, ...AZn) automatisch von den Einspeiseleitern (E1, E2) trennen.

9. Verfahren nach einem der Ansprüche 6 bis 8, **dadurch gekennzeichnet, dass** die Verbindung des jeweiligen Einspeiseleiters (E1, E2) mit Erdpotential nach einer vorgebbaren zeitlichen Abfolge erfolgt.

10. Verfahren nach einem der Ansprüche 6 bis 9, **dadurch gekennzeichnet, dass** die zwei Einspeiseleiter (E1, E2) auf Isolationsfehler gegen Erde geprüft werden, und dass nach Feststellung eines Isolationsfehlers gegen Erde die Einspeiseleiter (E1, E2) wahlweise mit Erdpotential verbunden werden.

11. Verfahren nach Anspruch 10, **dadurch gekennzeichnet, dass** ausschließlich jener Einspeiseleiter (E1, E2) mit Erdpotential verbunden wird, welcher den Isolationsfehler gegen Erde aufweist.

## Claims

1. Circuitry to localize insulation ground faults in direct voltage networks, this circuitry having the voltage of a direct voltage source (1) applied to two supply conductors (E1, E2) of the direct voltage network having at least two branches (AZ1, AZ2, ... AZn),
**characterized by**
a selector switch (8) for optional connection of the supply conductors (E1, E2) with ground potential and a detection device (7) associated with each branch to be checked (AZ1, ... AZn) to detect a change in current in the branch.

2. Circuitry according to claim 1, **characterized in that** the direct voltage source (1) and the supply conductors (E1, E2) have a fault detection device (2) arranged between them to detect and evaluate network parameters, the fault detection device (2) being set up to compare actual values of the network parameters with definable setpoints and, if a definable deviation from the setpoints occurs, the selector switch (8) being changed from an idle state into an activated state by a drive (6) that allows the optional connection of the supply conductors (E1, E2) with ground potential exclusively during the activated state.

3. Circuitry according to claim 2, **characterized in that** the fault detection device (2) is a resistor network with at least one voltage measurement device.

4. Circuitry according to claim 1 or 2, **characterized in that** the selector switch (8) and the ground potential have an auxiliary resistor (10) between them that can be short-circuited by means of a auxiliary switch (11).

5. Circuitry according to any one of claims 1 through 4, **characterized in that** at least one branch (AZ1) has line protection elements (9) that are controllable by the detection device (7).

6. A process for localizing insulation faults wherein a direct voltage source (1) supplies supply conductors (E1, E2) of a network having at least two branches (AZ1, AZ2, ... AZn), the supply conductors (E1, E2) being optionally connected with ground potential and a change at least in the current in the branches (AZ1, AZ2, ... AZn) caused by this being detected.

7. A process according to claim 6, **characterized in that** the detected change at least in the current is tested according to definable criteria and, depending on the result of the test, line protection mechanisms associated with the branches (AZ1, AZ2, ... AZn) are controlled.

8. A process according to claim 6, **characterized in that** the detected change at least in the current is tested according to definable criteria and, depending on the result of the test, line protection mechanisms associated with the branches (AZ1, AZ2, ... AZn) automatically separate the branches (AZ1, AZ2,.... AZn) from the supply conductors (E1, E2).

9. A process according to any one of claims 6 through 8, **characterized in that** the respective supply conductor (E1, E2) is connected with ground potential according to a definable time sequence.

10. A process according to any one of claims 6 through 9, **characterized in that** the two supply conductors (E1, E2) are tested for insulation ground faults and **in that** after an insulation ground fault is found the supply conductors (E1, E2) are optionally connected with ground potential.

11. A process according to claim 10, **characterized in that** exclusively the supply conductor (E1, E2) that has the insulation ground fault is connected with ground potential.

## Revendications

1. Agencement de circuit pour la localisation de défauts d'isolation par rapport à la terre dans des réseaux à tension continue, suivant lequel la tension d'une source de tension continue (1) est appliquée à deux conducteurs d'alimentation (E1, E2) du réseau à tension continue présentant au moins deux dérivations (AZ1, AZ2, ..., AZn)
**caractérisé par**
un commutateur de sélection (8) pour la connexion sélective des conducteurs d'alimentation (E1, E2) à un potentiel de terre ainsi qu'un dispositif de détection (7) associé à chaque dérivation (AZ1, ..., AZn) à examiner pour la détection d'un changement de courant dans la dérivation.

2. Agencement de circuit selon la revendication 1, **caractérisé par le fait qu'**un dispositif (2) de reconnaissance de défauts pour la détection et l'évaluation de paramètres de réseau est disposé entre la source de tension continue (1) et les conducteurs d'alimentation (E1, E2), le dispositif (2) de reconnaissance de défauts étant aménagé pour la comparaison de valeurs réelles des paramètres de réseau avec des valeurs de consigne prédéterminables et lors de l'entrée d'une déviation prédéterminable des valeurs de consigne, une commande (6) pour le commutateur de sélection (8) passe d'un état au repos à un état activé, la commande (6) autorise la connexion sélective des conducteurs d'alimentation (E1, E2) au potentiel de terre exclusivement pendant la durée de l'état activé.

3. Agencement de circuit selon la revendication 2, **caractérisé par le fait que** le dispositif (2) de reconnaissance de défauts est un réseau résistif ayant au moins un dispositif de mesure de tension.

4. Agencement de circuit selon l'une des revendications 1 ou 2, **caractérisé par le fait qu'**une résistance auxiliaire (10) pouvant être court-circuitée au moyen d'un commutateur auxiliaire (11) est prévue entre le commutateur de sélection (8) et le potentiel de terre.

5. Agencement de circuit selon l'une des revendications 1 à 4, **caractérisé par le fait qu'**au moins une dérivation (AZ1) présente des éléments (9) de protection de lignes commandables par le dispositif de détection (7).

6. Procédé de localisation de défauts d'isolation, suivant lequel une source de tension continue (1) alimente des conducteur d'alimentation (E1, E2) d'un réseau présentant au moins deux dérivations (AZ1, AZ2, ..., AZn), les conducteurs d'alimentation (E1, E2) étant connectés de façon sélective au potentiel de terre et un changement provoqué par cela au moins du courant étant détecté dans les dérivations (AZ1, AZ2, ..., AZn).

7. Procédé selon la revendication 6, **caractérisé par le fait que** le changement détecté au moins du courant est examiné d'après des critères prédéterminables et en fonction du résultat de cela, des mécanismes de protection de lignes associés aux dérivations (AZ1, AZ2, ..., AZn) sont commandés.

8. Procédé selon la revendication 6, **caractérisé par le fait que** le changement détecté au moins du courant est examiné d'après des critères prédéterminables et en fonction du résultat de cela, des mécanismes de protection de lignes associés aux dérivations (AZ1, AZ2, ..., AZn) séparent les dérivations (AZ1, AZ2, ..., AZn) automatiquement des conducteurs d'alimentation (E1, E2).

9. Procédé selon l'une des revendications 6 à 8, **caractérisé par le fait que** la connexion du conducteur d'alimentation respectif (E1, E2) au potentiel de terre a lieu après une séquence temporelle prédéterminable.

10. Procédé selon l'une des revendications 6 à 9, **caractérisé par le fait que** les deux conducteurs d'alimentation (E1, E2) sont examinés vis-à-vis de défauts d'isolation par rapport à la terre, et **par le fait qu'**après constatation d'un défaut d'isolation par rapport à la terre, les conducteurs d'alimentation (E1, E2) sont connectés de façon sélective au potentiel de terre.

11. Procédé selon la revendication 10, **caractérisé par le fait qu'**exclusivement le conducteur d'alimentation (E1, E2) est connecté au potentiel de terre, lequel présente le défaut d'isolation par rapport à la terre.
